# EUROPEAN PATENT SPECIFICATION

(11) **EP 0 622 852 B1**
(45) Date of publication and mention of the grant of the patent: **28.05.1997**
(21) Application number: 93114430.7
(22) Date of filing: 08.09.1993
(51) Int. Cl.: H01L 29/10, H01L 29/812, H01L 21/338

(54) **A field effect transistor**
Feldeffekttransistor
Transistor à effet de champ

(30) Priority: 30.03.1993 JP 71380/93
(43) Date of publication of application: 02.11.1994
(73) Proprietor: MITSUBISHI DENKI KABUSHIKI KAISHA, Tokyo 100 (JP)
(72) Inventor: Sakai, Masayuki, c/o Mitsubishi Denki K.K., Hikari, Itami-shi, Hyogo 664 (JP)
(74) Representative: KUHNEN, WACKER & PARTNER

(56) References cited:
- EP-A- 0 175 864
- EP-A- 0 305 975
- JP-A- 3 066 167
- US-A- 4 394 674
- 1990 IEEE MTT-S INTERNATIONAL MICROWAVE SYPOSIUM DIGEST, vol.III, 8 May 1990 pages 1077 - 1080, XP144134 P.C. CANFIELD ET AL.
- PATENT ABSTRACTS OF JAPAN vol. 16, no. 291 (E-1224) 26 June 1992 & JP-A-04 075 387 (SONY CORP.) 10 March 1992

## Description

### FIELD OF THE INVENTION

The present invention relates to a field effect transistor and a production method therefor, and more particularly, to the improvement of the source to drain breakdown voltage of a compound semiconductor field effect transistor.

### BACKGROUND OF THE INVENTION

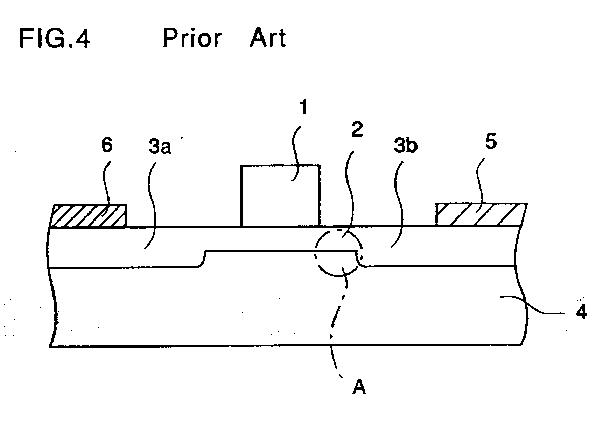

Figure 4 is a cross-sectional view illustrating a structure of a prior art refractory metal gate field effect transistor. In the figure, reference numeral 4 designates a semi-insulating intrinsic layer or p-type layer of a compound semiconductor substrate comprising, for example, GaAs or the like. An n-type active layer 2 serving as channel is produced at the surface region of the compound semiconductor substrate 4 by implanting n-type impurity, for example, Si or the like into the surface region of the compound semiconductor substrate 4. A refractory metal gate comprising WSi or the like is produced on the n-type active layer 2 serving as a channel. High concentration n-type layers 3a and 3b which are to become a source and a drain regions, respectively, are produced at the n-type active layer 2 serving as channel by impurity plantation at the both sides of the gate electrode 1. A source electrode 6 and a drain electrode 5 are disposed on the high concentration n-type source and drain layer 4, respectively. In the figure, reference character A designates a region of high electric field produced at a region in the channel in vicinity of the drain region end between the gate and the drain region, and in this high electric field region collision ionization, which will be discussed later, occurs.

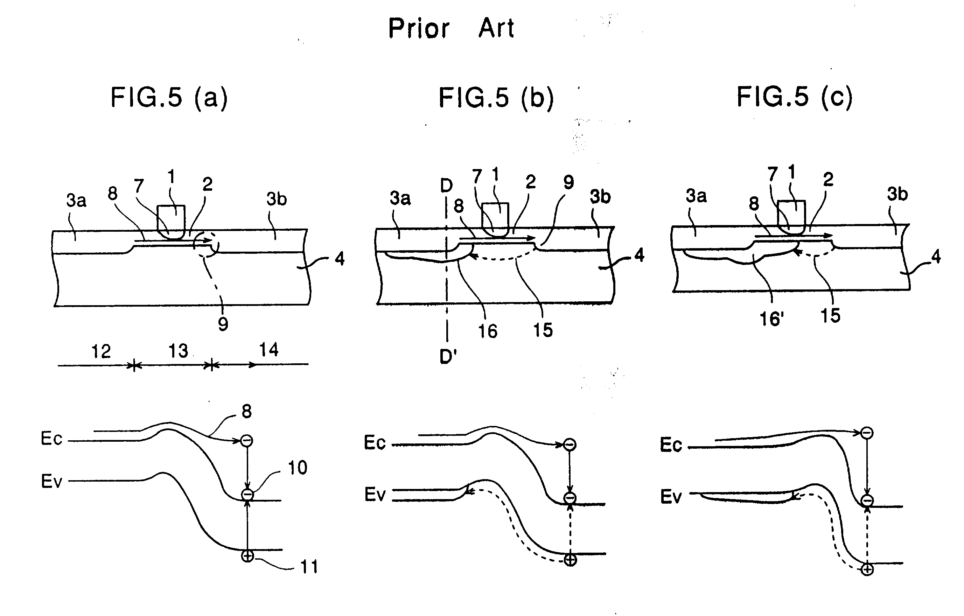

A description is given with reference to figure 5 as to how the drain breakdown voltage, i.e., the voltage at which breakdown occurs in a state where a large current is flowing between the source electrode 6 and the drain electrode 5 is determined, in the above-described compound semiconductor field effect transistor.

In figure 5(a), (b), and (c), reference numeral 1 designates a refractory metal gate, reference numeral 2 designates an n-type channel layer, reference numerals 3a and 3b designate respectively a source and a drain high concentration n-type layers, reference numeral 7 designates a depletion layer below the gate produced in the channel layer 2, reference numeral 8 designates a flow of an electron from the source region 3a to the drain region 3b in the below-gate depletion layer 7, and reference numeral 9 designates a high electric field region in the channel 2 between the gate and the drain where collision ionization occurs at an end part of the electron flow 8 in the below-gate depletion layer 7 at the drain end. Reference numeral 10 designates an electron which has lost energy due to the collision ionization. Reference numeral 11 designates a positive hole generated due to the collision ionization. Reference numeral 12 designates a source region, reference numeral 13 designates a gate region, and reference numeral 14 designates a drain region. Reference numeral 15 designates a flow of positive hole and reference numeral 16 designates a region where the concentration of positive holes is increased. Reference character E_{c} designates an energy of the conduction band of a compound semiconductor and reference character Eᵥ designates an energy of the valence band of the compound semiconductor.

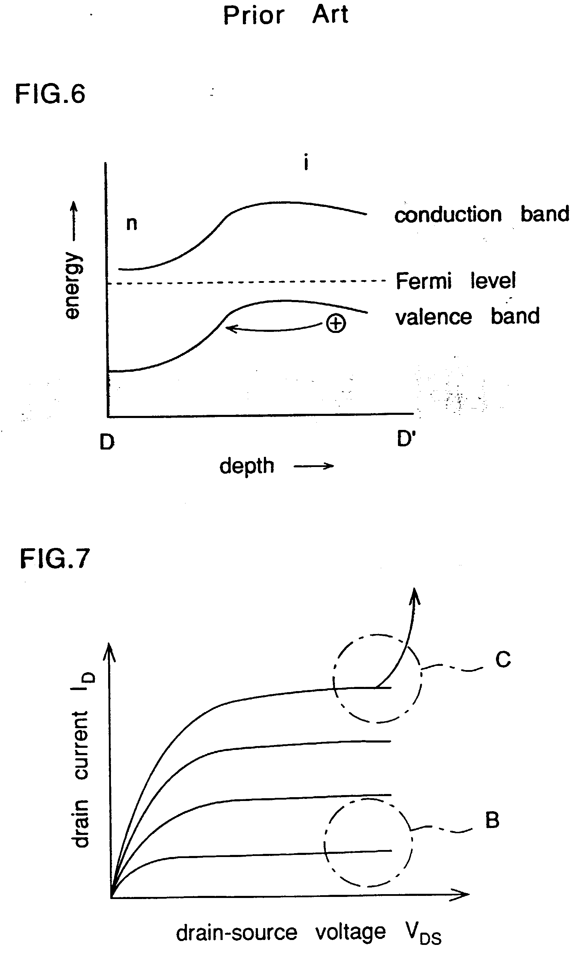

Figure 6 shows an energy band structure where the abscissa represents the depth along the line D-D' in figure 5(b) and the ordinate represents the energy band structure at that depth position.

In the operation of this field effect transistor, the electron flowing in the n-type channel layer 2 from the source side 6 to the drain side 5 is accelerated by a high electric field at the high electric field region A produced between the gate and the drain, and it occurs collision ionization at a region in the vicinity of the drain end 9, thereby generating electron-hole pairs 10 and 11 (figure 5(a)).

The holes generated at the drain end 9 region move toward the source 6 side by being pulled toward that side as shown by the dotted line of figure 5(b), and due to the potential wall of about 1V existing between the n-type channel layer 2 and the semi-insulating i-type layer (or p-type layer) 4, a region of high hole concentration 16 is generated at the source 6 side in a stable state (figure 5(b)).

When the electric field is further intensified, the acceleration of the electron by the high electric field is further strengthened and the collision ionization at the drain end 9 region is further increased, whereby the amount of electron-hole pair generation is further increased and the high concentration hole region 16' at the source 6 side extends out closer to the drain 5 side as shown in figure 5(c).

As a result of the above-described process, the electric field of the high concentration hole region 16' extending out to the drain 5 side is weakened, whereby the distance between the high concentration hole region 16' and the drain end 9 is shortened, and further, the electric field at the drain end 5 region is strengthened. Therefore, the generation of the electron-hole pair is further increased at the drain end 9 region, thereby constituting a positive feedback, and finally reaching a breakdown.

In this way, in this field effect transistor, the holes which can move freely in the high concentration positive hole region, move so that they may cancel the electric field applied thereto thereby to weaken that electric field, and when these holes are increasingly produced in this way and these are produced at closer to the drain side, the electric field at a region between the high concentration positive hole region and the end of the drain region is further strengthened, thereby destroying the p-n junction at the drain end, leading to a breakdown.

In this prior art field effect transistor, the drain breakdown voltage is determined according to the above-described process.

In the prior art field effect transistor, holes generated at the drain end 9 region are accumulated in the substrate at the source side as described above, and the electric field intensity at the drain end 9 region is further strengthened, and this promotes the collision ionization which finally leads to a breakdown, i.e., a drain breakdown. In the prior art field effect transistor, only a drain breakdown voltage of 6V to 7V is obtained.

As another prior art, Japanese Patent Published Application No. 61-264764 discloses a non-volatile semiconductor memory in which a p⁺ type high concentration diffusion layer adjacent to an N⁺ type source diffusion layer is provided so as to stray charges to the ground.

In EP-A-305 975 (corresponding to the preamble of claim 1) a compound semiconductor MESFET is disclosed with a p-type layer below the n⁺-source.

However, this prior art aims at preventing positive holes from entering the floating gate and does not aim at improving the breakdown voltage of FET.

### SUMMARY OF THE INVENTION

It is an object of the present invention to provide a compound semiconductor field effect transistor that has an improved drain breakdown voltage.

According to a first aspect of the present invention according to claim 1, an n type high concentration source layer is partially surrounded by a p type layer and this p type layer is grounded. By this construction, the positive holes generated at the high electric field region at drain end and having flown into the source side directly flow into the ground voltage without being stored at the source side, thereby the likelihood that the positive holes stored at source side intensifies the electric field at the drain side thereby occurring a breakdown can be suppressed.

According to the present invention, by that the n type source high concentration region is surrounded by a p type layer and the positive holes which have flown into the source side are made stray out to the ground through the high concentration p type layer, it can be suppressed that the positive holes generated at the drain side are stored at the source side thereby to weaken the electric field in the substrate at the source side, while the high concentration positive hole region is extended to the drain side thereby strengthen the electric field at the drain end. This results increasing the drain breakdown voltage.

### BRIEF DESCRIPTION OF THE DRAWINGS

Figure 1 is a cross-sectional view illustrating a field effect transistor according to an embodiment of the present invention.

Figure 2 is a cross-sectional view illustrating an example of a field effect transistor.

Figures 3(a) to 3(g) are diagrams illustrating a production flow for producing the field effect transistor of figure 1.

Figure 4 is a cross-sectional view illustrating a prior art refractory metal gate field effect transistor.

Figures 5(a) to 5(c) are schematic diagrams for explaining a drain breakdown voltage of the prior art refractory metal gate field effect transistor.

Figure 6 is a diagram illustrating an energy band structure where the abscissa represents the depth along the line D-D' in figure 5(b) and the ordinate represents the energy band structure for the respective depth position.

Figure 7 is a diagram showing the drain to source voltage vs. drain current characteristics of a field effect transistor, and a relation between the source to drain breakdown of a planar type field effect transistor and the gate to drain breakdown of the recess type field effect transistor.

### DETAILED DESCRIPTION OF THE REFERRED EMBODIMENT

### Embodiment 1.

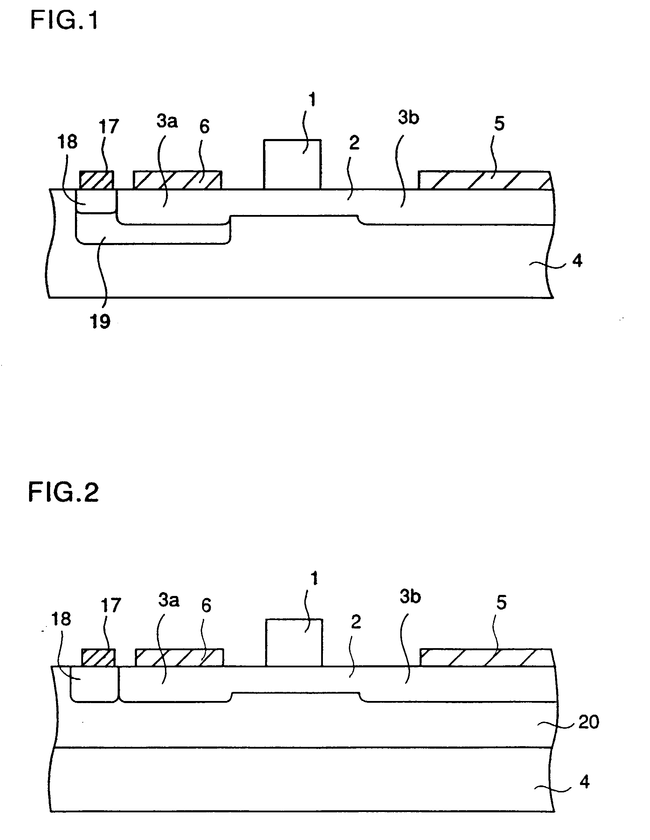

Figure 1 is a diagram illustrating a semiconductor field effect transistor according to a first embodiment of the present invention. In the figure, reference numeral 4 designates a semi-insulating or an intrinsic layer of a compound semiconductor substrate such as GaAs or the like. An n-type active layer 2 serving as a channel of impurity concentration of 1 to 5 x 10¹⁷ cm⁻³ and a thickness of about 1000 Å (1Å = 0.1 nm) is produced at the surface region of the compound semiconductor substrate 4. A refractory metal gate 1 comprising WSi or the like is produced on the n-type active layer 2 serving as a channel and the height of the gate 1 is about 3000 Å and the gate length is about 0.3 to 0.4 µm. High concentration n-type layers 3a and 3b of impurity concentration of about 5 x 10¹⁸ cm⁻³ serving as a source region and a drain region, respectively, are produced at the n-type active layer 2 serving as a channel at the both sides of the gate electrode 1 by impurity implantation to a depth a little larger than that of the channel layer. The interval between the source region and the drain region is about 3 µm. A source electrode 6 (n side electrode) and a drain electrode 5 comprising AuGe/Ni/Au are produced on the high concentration n-type layers 3a and 3b, respectively, in about 2500 Å thick.

A p-type high concentration layer 18 of impurity concentration of 1 x 10²⁰ cm⁻³ is produced outside the high concentration n-type layer 3a at the source side. A p-type ohmic electrode 17 is disposed on the p-type high concentration layer 18 in contact therewith. A p-type layer 19 of impurity concentration of about 10¹⁶ to 10¹⁸ cm⁻³ and of a depth of 2000 to 3000 Å is produced under the high concentration n-type layer 3a at the source side and the p-type high concentration layer 18. The electrode (p side electrode) comprising Ti/Pt/Au or Ti/Mo/Au is produced on the p-type layer 18 in about 2500 Å thick. When a circuit is constructed, the electrode 17 on the p-type layer 18 and the source electrode 6 are connected to each other to constitute a source grounded circuit.

In the structure of this embodiment shown in figure 1, the p-type layer 19 is provided below the p-type high concentration layer 18 and the source side high concentration n-type layer 3a as well as the p-type high concentration layer 18 is provided outside the source side high concentration n-type layer 3a in contact therewith, and the ohmic electrode 17 is provided on the p-type high concentration layer 18. Therefore, the positive holes generated at the drain (5) side region and flowing to the source (6) side region are structurally grounded by the p-type ohmic electrode 17 through the p-type high concentration layer 18.

Therefore, the positive holes generated at the drain end 9 region are not stored in the substrate at the source side, but flow to the ground even when they flow to the source side. As a result, it never occurs that the positive holes are stored at the source side thereby to further strengthen the electric field at the drain end 9 region, finally leading to a breakdown, thereby greatly improving the drain breakdown voltage of the field effect transistor. By such a structure, a breakdown voltage of above 10V is obtained.

While the present invention relates to a technique of improving the drain breakdown voltage, in a planar FET, when the gate to drain voltage is increased, the gate to drain destruction occurs, leading to a breakdown before the drain current reaches a fairly large value. In other words, the gate to drain breakdown voltage in a planar type FET is always lower than that of the recess type FET, and in order to solve the problem that the gate to drain breakdown voltage (corresponding to the gate breakdown voltage) is low, a gate is produced offset or a recess type gate is provided. In such recess type MESFET, however, although the gate breakdown voltage as well as the drain breakdown voltage are increased by adopting the recess type structure, such recess type MESFET requires a recess etching, resulting in a complicate production process.

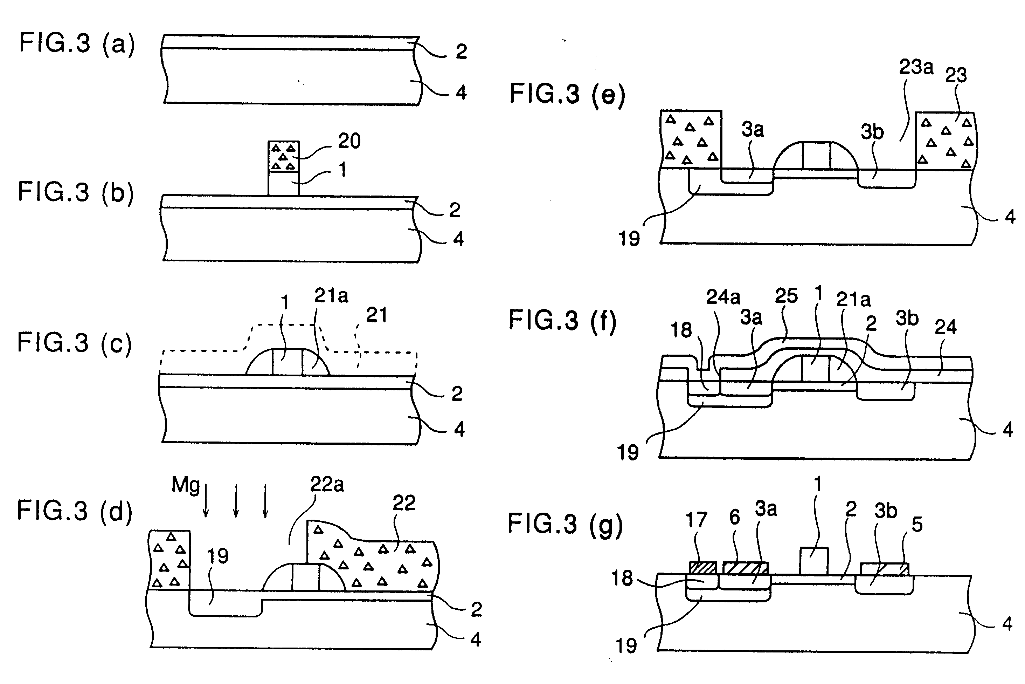

To the contrary, when the present invention is employed, it is possible with keeping the transistor structure in a planar type to obtain an MESFET having a high drain breakdown voltage in a planar type MESFET in which drain breakdown voltage appears prior to the gate breakdown voltage by using jointly the gate offset and the method of Figs 3a - 3g.

This fact will be described in more detail with reference to figure 7. In a recess type field effect transistor, the external source and drain layer (ohmic contact formation layer) is thicker relative to the thickness of the channel layer direct below the gate, and even when positive holes extend out to the drain side, the effect that the electric field between the gate and the drain is increased thereby is suppressed. In comparison with a planar type one, the breakdown due to the destruction between the source and the drain when a smaller source to drain current flows, i.e., the destruction and breakdown at the part B in the drain to source voltage versus drain current characteristics shown in figure 7 appears prior to the breakdown between the gate and the drain when a larger source to drain current flows, i.e., the destruction and breakdown at the part C in the characteristics shown in figure 7, thereby resulting in a gate breakdown voltage lower than the drain breakdown voltage.

On the other hand, in a planar type field effect transistor, although it is possible to increase the gate to drain breakdown voltage by enlarging the distance between the gate and the drain, the drain to source breakdown voltage when a larger current flows cannot be increased even by increasing the distance between the gate and the drain, resulting in that the destruction at the part C shown in figure 7 occurs prior thereto. Therefore, increasing the drain to source breakdown voltage is requested.

As discussed above, in the field effect transistor of the first embodiment of the present invention, so as not to accumulate the positive holes flowing from the drain 5 side region to the source 6 side region due to the high electric field region produced at the drain 5 side region to a high concentration, the p-type layer 19 is provided outside the source region 3a, and the p-type layer 19 is provided surrounding the source region 3a to make the positive holes stray to the ground through the high concentration p-type layer 18. Therefore, it is avoided that the positive holes generated at the drain side region are accumulated at the source side region thereby to weaken the electric field in the substrate at the source side region as well as the high concentration positive hole region extends out to the drain side, thereby strengthening the electric field at the drain end region at the drain side, whereby the drain breakdown voltage of the planar type FET can be largely increased.

Figure 2 is a cross-sectional view illustrating an example of a field effect transistor. In the figure, reference numeral 20 designates a p-type layer of impurity concentration of about 10¹⁶ cm⁻³ inserted between the semiconductor substrate 4 and the channel layer 2. The other constructions except for providing this p-type layer 20 are the same as those of the first embodiment shown in figure 1 and the operation is almost the same as that of the first embodiment. However, it is possible to make the effective channel thickness thinner by the p-n junction produced under the channel, thereby improving the gain of the transistor.

Figure 3 shows cross-sectional views for illustrating a production method of a field effect transistor according to Fig. 1 (embodiment of the present invention). This third embodiment is an embodiment of a method for producing the field effect transistor of the above-described first embodiment shown in figure 1. The production method will be described with reference to figure 3 in the following.

First, an n-type channel layer 2 of impurity concentration of about 1 to 5 x 10¹⁷ cm⁻³ is produced on the compound semiconductor substrate 4 (Figure 3(a)).

Next, a refractory metal 1, for example WSi, is sputtered on the entire surface, and thereafter, this refractory metal is processed to a gate configuration by performing a dry etching using a gas mixture of CHF₃ and SF₆ using a resist mask 20 as the mask, thereby producing a gate electrode 1 (Figure 3(b)).

Next, after removing the mask 20, SiO insulating film 21 is produced to about 3000Å thickness on the entire surface, this is etched back by anisotropically etching using a gas mixture of CHF₃ and O₂, thereby producing side walls 21a of about 3000 Å width in the transverse direction (Figure 3(c)).

Next, a resist pattern 22 having an opening 22a only at the source side is produced, and p-type impurity, for example, Mg is ion-implanted from the opening 22a so that the n-type channel layer 2 can be inverted to p-type or more and a concentration peak may come to a deep position of about 2000 Å from the surface, thereby producing a p-type layer 19 (Figure 3(d)).

Next, a resist pattern 23 having an opening 23a over the region from the source region 3a to the drain region 3b is produced, and n-type impurity, for example, Si is ion-implanted from the opening 23a, and after removing the resist, the device is heated to a temperature of 500 to 550 C to perform an annealing, and the implanted impurities are diffused, thereby producing a source region 3a and a drain region 3b (Figure 3(e)).

Next, an insulating film 24, for example, a plasma SiN film, having an opening 24a at the outside (opposite side of the drain region 3b) of the source region 3a at the source side is produced, thereafter, a ZnO film 25 is spattered, and using the SiN film 24 as a mask, solid phase diffusion is carried out to diffuse Zn into the p-type layer 19 from the ZnO film 25 at the opening 24a of the SiN film 24, thereby producing a p-type high concentration layer 18 of impurity concentration of about 1 x 10²⁰ cm⁻³ (Figure 3(f)).

Next, ohmic electrodes 6, 5, and 17 are respectively produced on the source region 3a, the drain region 3b, and the Zn diffusion layer 18 (Figure 4(g)).

In the production method of a field effect transistor according to this embodiment, the field effect transistor having the structure shown in figure 1 can be easily produced.

A method for producing the field effect transistor as shown in figure 2 can be obtained only by omitting the process of producing the p-type layer 19 in figure 3(d) in the production process of an FET as shown in figure 3. Accordingly, the field effect transistor of Fig. 2 can be easily produced.

A further method for producing the field effect transistor shown in figure 1 is obtained by previously producing the p-type layer 19 below the n-type channel layer 2 in the first process shown in figure 3(a) and omitting the process shown in figure 3(d) corresponding thereto in the production method of a field effect transistor as shown in figure 3.

The field effect transistor of the structure shown in figure 1 can be more easily obtained than by this further method.

Although the above-described prior art, Japanese Patent Published Application No. 61-264764, is common to the present invention in that a p-type layer is provided at the source and it is grounded so as to stray positive holes to the source side, this prior art publication does not concern compound semiconductor MESFETs as in the present invention, but concerns silicon devices. Therefore, the insertion of p-type layer has not come from the view of increasing the drain breakdown voltage, and also the operation mechanism and principle are quite different.

In addition, there are some techniques of providing a p-type region to prevent interferences between circuit elements, which p-type region is connected to ground. However, these conventional techniques only provides a ground between circuits and do not provide a boundary region of a ground voltage between circuits and do not provide a p-type region in an FET element, which p-type region is grounded.

As discussed above, according to the present invention, a p-type layer is produced surrounding a high concentration n-type layer at the source side, and the source is grounded through the high concentration p-type layer. Therefore, it can be avoided, that positive holes generated at the drain end region are accumulated at the source side region thereby to weaken the electric field in a substrate at the source side region as well as the high concentration positive hole region extends out to the drain side thereby to strengthen the electric field at the drain side, finally leading to a breakdown. This results a great improvement in the drain breakdown voltage at the drain side region.

## Claims

1. Field effect transistor which includes a metal-semiconductor junction serving as a gate electrode (1) which is provided on a channel layer (2) of a first conductivity type (n) which layer, in turn, is provided in the surface of an intrinsic or semi-insulating compound semiconductor substrate (4) having a surfae, said field effect transistor further comprising:
**[a]** a source region layer (3a) of said first conductivity type (n) having an impurity concentration higher than that of said channel layer (2),
**[b]** a source electrode (6) provided on said source region layer (3a);
**[c]** a second conductivity type (p) layer (19) provided below said source region layer (3a), outside thereof and in contact therewith;
**[d]** a second conductivity type (p) high impurity concentration layer (18) having a higher dopant impurity concentration than that of said second conductivity type (p) layer (19), provided in said semiconductor substrate (4) extending from said surface and contacting said second conductivity type (p) layer (19) ; and
**[e]** a second electrode (17) disposed on and contacting said second conductivity type (p) high impurity concentration layer (18);
*characterized in that*
**[l]** said second conductivity type (p) layer (19) is provided so as to surround only aid source region layer (3a) with the exception of that side where said source region layer (3a) is contacting said channel layer (2);
**[g]** said second conductivity type (p) high impurity concentration layer (18) is provided in contact with said source region layer (3a); and
**[h]** said source electrode (6) and said second electrode (17) are both grounded to earth.

## Patentansprüche

1. Feldeffekttransistor, welcher einen Metall/Halbleiter-Übergang aufweist, der als eine Gateelektrode (1) dient, welche auf einer Kanalschicht (2) eines ersten Leitfähigkeitstyps (n) vorgesehen ist, wobei diese Schicht weiterhin in der Oberfläche eines intrinsischen oder halbisolierenden Verbindungshalbleitersubstrats (4) vorgesehen ist, das eine Oberfläche aufweist, wobei der Feldeffekttransistor weiter aufweist:
**[a]** eine Sourcebereichsschicht (3a) des ersten Leitfähigkeitstyps (n), die eine Störstellenkonzentration aufweist, die höher als die der Kanalschicht (2) ist,
**[b]** eine Sourceelektrode (6), die auf der Sourcebereichsschicht (3a) vorgesehen ist;
**[c]** eine Schicht (19) eines zweiten Leitfähigkeitstyps (p), die unter der Sourcebereichsschicht (3a), außerhalb davon und sich damit in Kontakt befindend vorgesehen ist;
**[d]** eine Schicht (18) einer hohen Störstellenkonzentration des zweiten Leitfähigkeitstyps (p), die eine höhere Dotierstoffstörstellenkonzentration als die der Schicht (19) des zweiten Leitfähigkeitstyps (p) aufweist, die sich von der Oberfläche ausdehnend und mit der Schicht (19) eines zweiten Leitfähigkeitstyps (p) in Kontakt befindend in dem Halbleitersubstrat (4) vorgesehen ist; und
**[e]** eine zweite Elektrode (17), die auf der Schicht (18) einer hohen Störstellenkonzentration des zweiten Leitungstyps (p) angebracht ist und sich damit in Kontakt befindet;
*dadurch gekennzeichnet, daß*
**[f]** die Schicht (19) des zweiten Leitfähigkeitstyps (p) derart vorgesehen ist, daß sie mit Ausnahme der Seite, an der sich die Sourcebereichsschicht (3a) mit der Kanalschicht (2) in Kontakt befindet, nur die Sourcebereichsschicht (3a) umgibt;
**[g]** die Schicht (18) einer hohen Störstellenkonzentration des zweiten Leitfähigkeitstyps (p) sich mit der Sourcebereichsschicht (3a) in Kontakt befindend vorgesehen ist; und
**[h]** sowohl die Sourceelektrode (6) als auch die zweite Elektrode (17) an Masse gelegt sind.

## Revendications

1. Transistor à effet de champ qui comprend une jonction métal-semi-conducteur servant comme une électrode de grille (1) qui est prévue sur une couche de canal (2) d'un premier type de conductivité (n) laquelle couche, à son tour, est prévue dans la surface d'un substrat semi-conducteur composé intrinséque ou semi-isolant (4) ayant une surface, ledit transistor à effet de champ comprenant de plus :
[a] une couche de région de source (3a) dudit premier type de conductivité (n) ayant une concentration d'impuretés supérieure à celle de ladite couche de canal (2),
[b] une électrode de source (6) prévue sur ladite couche de région de source (3a);
[c] une couche (19) d'un second type de conductivité (p) prévue en dessous de ladite couche de région de source (3a), à l'extérieur de celle-ci et en contact avec celle-ci;
[d] une couche (18) à concentration d'impuretés élevée d'un second type de conductivité (p) ayant une concentration d'impuretés de dopants plus élevé que celle de la couche (19) du second type de conductivité (p), prévue dans ledit substrat semi-conducteur (4) s'étendant de ladite surface et contactant ladite couche (19) du second type de conductivité (p); et
[e] une seconde électrode (17) disposée sur ladite couche (18) d'une concentration d'impuretés élevée du second type de conductivité (p) et contactant celle-ci;
caractérisé en ce que
[f] ladite couche (19) du second type de conductivité (p) est prévue afin d'entourer seulement ladite couche de région de source (3a) à l'exception du côté où ladite couche de région de source (3a) contacte ladite couche de canal (2);
[g] ladite couche (18) de concentration d'impuretés élevée du second type de conductivité (p) est prévue en contact avec ladite couche de région de source (3a); et
[h] ladite électrode de source (6) et ladite seconde électrode (17) sont toutes les deux mises à la masse.
